(19) Europäisches Patentamt

**European Patent Office**

**Office européen des brevets**

(11) Numéro de publication: **0 407 312 A1**

## (12) DEMANDE DE BREVET EUROPEEN

(21) Numéro de dépôt: **90420311.4**

(22) Date de dépôt: **03.07.90**

(51) Int. Cl.⁵: **C23C 16/14**

(30) Priorité: **05.07.89 FR 8909451**

(43) Date de publication de la demande:
**09.01.91 Bulletin 91/02**

(84) Etats contractants désignés:
**DE FR GB**

(71) Demandeur: **Compagnie Européenne du Zirconium CEZUS**
**Tour Manhattan La Défense 2 6, place de l'Iris**
**F-92400 Courbevoie(FR)**

(72) Inventeur: **Boutin, Jean**
**12, rue de la Folie**
**F-95100 Argenteuil(FR)**
Inventeur: **Brun, Pierre**
**8, boulevard Maréchal Leclerc**
**F-38000 Grenoble(FR)**
Inventeur: **Lamaze, Airy-Pierre**
**40, rue Thiers**
**F-38000 Grenoble(FR)**

(74) Mandataire: **Vanlaer, Marcel et al**
**PECHINEY 28, rue de Bonnel**
**F-69433 Lyon Cédex 3(FR)**

(54) **Dispositif d'obtention de matériaux composés d'un substrat et d'un revêtement de titane purifié de forme plane.**

(57) L'invention est relative à un dispositif d'obtention de matériaux composés d'un substrat et d'un revêtement de titane purifié de forme plane dans lequel on met en oeuvre une cellule (5) d'halogénation garnie intérieurement près de sa paroi d'un panier (6) délimité par deux grilles (15) et (16) qui contient l'éponge (7) de titane à halogéner et vers le centre d'un substrat chauffé par effet Joule et sur lequel l'halogénure formé se décompose pour donner le revêtement de titane purifié.

Ce dispositif est caractérisé en ce que le substrat est formé d'au moins une série de deux plats (13) reliés électriquement entre eux qui s'allongent dans des plans sensiblement parallèles à la partie de la grille intérieure (5) du panier (6) la plus proche et sont équidistants de ladite grille.

Les matériaux obtenus sont utilisables directement sans refusion ou laminage intermédiaire à la confection de cibles de dépôt en phase vapeur pour composants électroniques ou de bandes destinées à la fabrication de condensateurs.

EP 0 407 312 A1

FIG.1

2

## DISPOSITIF D'OBTENTION DE MATERIAUX COMPOSES D'UN SUBSTRAT ET D'UN REVETEMENT DE TITANE PURIFIE DE FORME PLANE

La présente invention est relative à un dispositif d'obtention de matériaux composés d'un substrat et d'un revêtement de titane purifié de forme plane.

On sait que les circuits électroniques sont généralement constitués de composants multicouches. Pour réaliser ces composants, on peut utiliser la technique dite de dépôt en phase vapeur qui nécessite la mise en oeuvre des matériaux appelés cibles. Ces cibles ont souvent la forme de plats, de préférence circulaires, ayant une épaisseur de quelques centimètres. Sous l'action d'un faisceau d'électrons, par exemple, elles émettent des vapeurs qui sont condensées sur des supports où elles forment des couches successives et différentes suivant la composition de la cible et contribuent ainsi à la formation des composants multicouches recherchés.

Par ailleurs, dans le domaine de l'électrotechnique, on utilise des bandes métalliques plates qui après un traitement de surface destiné à développer des couches diélectriques servent à la réalisation de condensateurs.

Pour l'une ou l'autre de ces applications, il est donc nécessaire de disposer de matériaux ayant une forme plane.

Parmi les éléments utilisés pour réaliser ces matériaux, le titane tient une place relativement importante. Toutefois, pour jouer efficacement son rôle ce métal doit avoir une pureté supérieure ou égale à 99, 995%. Or, le titane obtenu industriellement ne titre guère plus de 99,95%. Il est donc nécessaire de le purifier avant de l'utiliser à la confection desdits matériaux. Cependant, il n'est pas indispensable de rechercher une purification à coeur de ces matériaux car la partie centrale n'aura pas à exercer les fonctions particulières qu'on demande aux parties environnantes. En effet, les cibles par exemple ne sont jamais vaporisées complètement. En conséquence, on pourra se contenter d'un matériau formé d'un substrat revêtu de titane purifié.

Cette purification est généralement obtenue par un procédé du type "VAN ARKEL" qui consiste à placer le titane à purifier sous forme d'éponge dans un panier délimité par deux grilles en forme de cylindres coaxiaux placés à la périphérie d'une cellule plongée dans un bain de sels fondus et au centre de laquelle est disposé un ou plusieurs substrats ayant la forme d'épingle à cheveux chauffé(s) par effet Joule. Dans cette cellule, on crée un vide relativement poussé et on injecte de l'iode. Cet iode réagit sur le titane pour former l'iodure TiI$_4$ qui se vaporise dans la cellule et vient en partie au contact du substrat lequel étant porté à une température voisine de 1500°C provoque la dissociation dudit iodure en donnant lieu à la formation de cristaux de titane purifié qui vont se déposer sur le filament et d'iode qui va servir à halogéner une nouvelle quantité d'éponge. La méthode "VAN ARKEL" conduit donc à la structure substrat-revêtement de titane purifié décrite plus haut.

Un tel procédé à été décrit par exemple dans le brevet japonais publié en 1987 sous le N° 62-47479. Mais on peut noter que le substrat du titane purifié est ici constitué par un fil de titane, c'est-à-dire que par définition, il a une section circulaire et formera après revêtement un matériau ayant une forme arrondie et non plane.

On ne pourra donc pas utiliser directement de tels matériaux dans les applications considérées ici et il faudra au préalable procéder à une refusion du revêtement suivie d'un laminage ou tout au moins d'un usinage pour obtenir les matériaux de forme plane qui conviennent. D'où des opérations coûteuses et entraînant des manipulations qui sont généralement la source de pollutions superficielles nuisibles à la qualité des matériaux fabriqués.

C'est pourquoi, la demanderesse a cherché une solution pour obtenir des matériaux présentant un revêtement de titane purifié ayant directement une forme plane afin de ne pas avoir recours après dépôt à un quelconque traitement de mise en forme polluant et coûteux.

Cette solution consiste en un dispositif qui, dans le cadre connu du dispositif de purification "VAN ARKEL" décrit plus haut, utilise un substrat formé d'au moins une série de deux plats reliés électriquement entre eux, qui s'allongent dans des plans sensiblement parallèles à la partie de la grille intérieure du panier la plus proche et sont équidistants de ladite grille.

Ainsi le dispositif selon l'invention diffère du dispositif de l'art antérieur en ce que le substrat sur lequel s'effectue le dépôt n'a pas une forme circulaire mais plane et qu'il est disposé de façon particulière à l'intérieur de la cellule.

Schématiquement, chaque série de deux plat à la configuration d'une épingle à cheveux qu'on aurait aplati ou encore d'un U; la liaison entre lesdits plats étant formée par une partie plate semi circulaire de même largeur que les branches du U. Mais tout autre type de liaison assurant une continuité électrique peut être envisagé.

Ces plats s'allongent de manière à être à la même distance de la grille intérieure du panier du haut en bas de leur longueur en faisant face à ladite grille et en étant placés chacun à la même distance de cette dernière.

Plus précisément, dans le cas d'une cellule circulaire, ces plats sont alignés sur un cercle concentrique du cercle formé par la grille intérieure. Dès lors, on conçoit que les deux plats formant un U ne soient pas situés dans un même plan mais dans deux plans formant entre eux un angle convenable; cet angle étant réalisé par pliage au niveau de la portion semi circulaire.

De préférence, la largeur d'un plat est comprise entre 0,5 et 2 fois la distance qui sépare le plat de la grille de manière à avoir un revêtement régulier et homogène.

Pour affiner davantage les résultats, on choisit cette largeur entre 0,75 et 1 fois la distance du plat à la grille.

Suivant les dimensions de la cellule, on utilise une ou plusieurs séries de plats. Toutefois, afin d'obtenir un dépôt de titane convenable, il faut que la largeur occupée par les plats sur le périmètre (ou circonférence) que dessine leur largeur soit inférieure ou égale à la longueur inoccupée sur ledit périmètre et mieux soit inférieure à la moitié deladite longueur. Cela détermine donc le nombre maximum de séries de deux plats utilisables.

Ces plats ont une épaisseur comprise entre 0,6 et 1 mm; une épaisseur inférieure à 0,6 mm conduit à une résistance mécanique insuffisante et une épaisseur supérieure à 1 mm est inutile.

De préférence, on choisit un titane de pureté industrielle pour réaliser lesdits substrats.

Par ailleurs, le chauffage de ces derniers est obtenu de façon classique par effet Joule car le chauffage par induction qui est parfois utilisé est mieux adapté aux substrats circulaires pour des raisons de symétrie dues à la forme des bobines génératrices des champs inductifs.

Outre, le fait qu'il fournit des matériaux directement utilisables, ce dispositif présente les avantages suivants:

- la structure du revêtement sur plat est beaucoup plus régulière, plus cohérente et adhère mieux au substrat que celle obtenue sur filament.
- en raison d'une surface plus grande du substrat, le dépôt peut être obtenu en chauffant ce dernier entre 1050 et 1150° C alors qu'avec un filament, cette température est généralement voisine de 1500° C. Du fait de cette réduction de température, la vitesse de diffusion des impuretés du substrat vers le revêtement est beaucoup plus faible et donc le titane déposé a une pureté beaucoup plus grande.
- en outre, une température de filament plus basse permet de faire travailler le bain de la cellule aux environs de 120-130° C au lieu de 300° C. De ce fait, la paroi métallique de la cellule d'halogénation est beaucoup moins sensible à la corrosion par les sous-iodures qui peuvent s'y condenser.

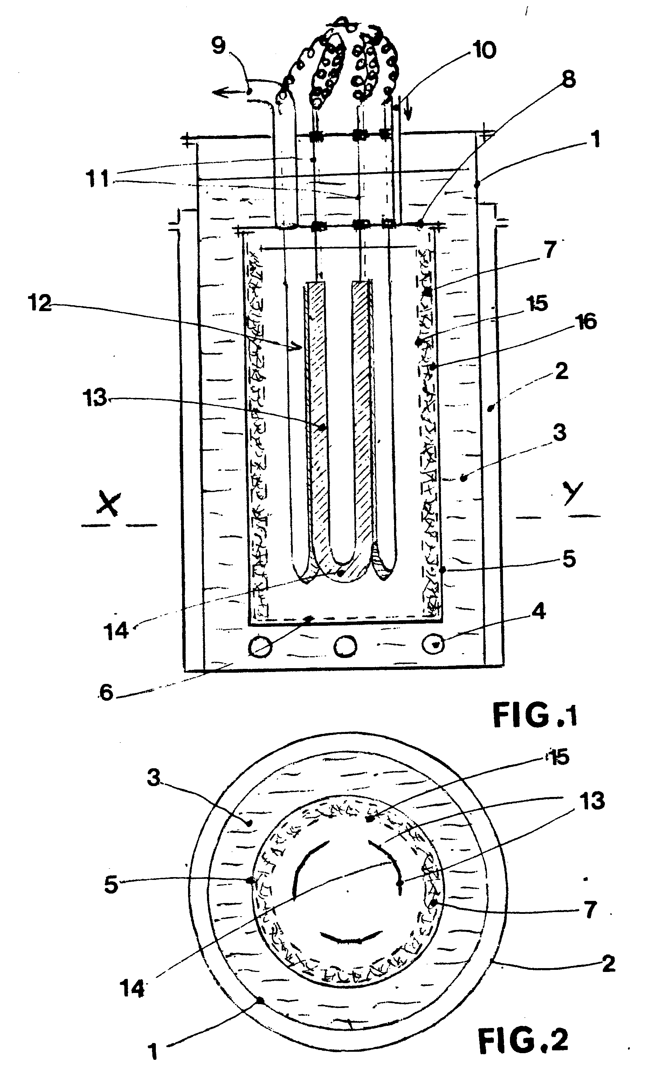

L'invention sera mieux comprise à l'aide de la planche de dessins qui représente à la figure 1 une coupe axiale verticale d'un dispositif d'obtention de matériaux composés d'un substrat et d'un revêtement de titane purifié de forme plane et à la figure 2 une coupe horizontale suivant la trace X Y de la figure 1.

De façon plus détaillée, on distingue sur la figure 1 une cuve 1 équipée d'une chemise 2 de refroidissement garnie intérieurement d'un bain 3 de sel fondu chauffé par les éléments 4 et dans laquelle plonge une cellule d'halogénation 5 contre la paroi interne de laquelle est logé un panier 6 délimité par deux grilles 15 et 16 en forme de cylindres coaxiaux et contenant l'éponge 7 de titane. Cette cellule est munie d'un couvercle 8 sur lequel sont placés une tuyauterie 9 reliée à un système de pompage destiné à créer une dépression à l'intérieur de ladite cellule, un piquage 10 d'amenée d'iode et des supports 11 reliés à une source de courant électrique destinée à chauffer par effet Joule le substrat 12 formé de trois séries de deux plats 13 reliés entre eux par une partie 14 semi circulaire.

Sur la figure 2, on distingue le substrat formé de trois séries de deux plats 13 disposés suivant une circonférence 14 entourés par la grille intérieure 15 du panier 6 contenant l'éponge 7 placé dans la cellule 5 qui plonge dans le bain 3 de sel fondu placé dans la cuve 1 munie de la chemise 2 de refroidissement.

L'invention peut être illustrée à l'aide des exemples d'application suivants qui établissent une comparaison entre les résultats de l'art antérieur (exemples 1 et 2) et ceux de l'invention (exemples 3 et 4).

## EXEMPLE 1

Suivant l'art antérieur, un filament en titane de diamètre 3,6 mm, de longueur 750 mm a été disposé dans une cellule d'halogénation contenant 10 kg d'éponge de titane contenant 500 ppm d'impuretés.

Après avoir introduit 500 g d'iode, porté la cellule à 100° C et le filament à 1400° C, on a déposé sur le filament à la vitesse de 7,5 à 10 g/h du titane ayant une teneur en impuretés de 50 ppm et formé une barre cristalline de diamètre moyen 25 mm et d'un poids de 1650 g environ. Les principales impuretés étaient en poids: fer < 10ppm; oxygène < 50 ppm; carbone<10 ppm.

EXEMPLE 2

Afin d'augmenter la vitesse de dépôt, on a porté la température de la cellule à 325° C toutes choses égales par ailleurs. On a obtenu des vitesses de l'ordre de 30 à 35 g/h et une barre de diamètre moyen 24 mm et d'un poids de 1520 g.

Toutefois, les teneurs en impuretés étaient passées en poids à: fer 25 ppm; oxygène 60 ppm; carbone 15 ppm.

Cela montre que l'augmentation de vitesse de dépôt consécutive à une élévation de température de la cellule se traduit par une élévation du niveau d'impuretés.

EXEMPLE 3

Dans la même cellule que celle utilisée dans les exemples précédents, on a disposé un substrat de titane en forme de U plat d'épaisseur 0,8 mm, de largeur (par branche) 40 mm et de hauteur 350 mm. En fixant la température de la cellule à 100° C et celle du substrat à 1050° C, on a obtenu un dépôt de titane purifié d'épaisseur 15 mm correspondant à une masse de 2360 g avec une vitesse de 41 g/h.

L'analyse de ce dépôt n'a pas permis de détecter la présence de fer, carbone, oxygène à des concentrations supérieures à 10 ppm en poids.

EXEMPLE 4

Dans une cellule cylindrique industrielle de diamètre de grille 500 mm, on a disposé trois substrats plats en forme de U d'épaisseur 0,8 mm, de largeur (par branche) 75 mm et de hauteur 1750 mm, distantes de la grille intérieure du panier de 100 mm et placées symétriquement sur un cercle de sorte que la largeur occupée par les plats était de 75x6 = 450mm sur un périmètre de 400x3,14 = 1256mm.

La cellule a été chargée avec 200 kg d'éponge ayant une teneur en impuretés voisine de 500 ppm. Après mise sous vide et chauffage de la cellule à 85° C, on a introduit 3,5 kg d'iode et porté les substrats à 1050° C. Après 281 heures, on a déposé 103,4 kg de titane sous forme de 3 U de largeur de branche 100 mm et d'épaisseur 25 mm. Bien que la vitesse de dépôt ait été nettement supérieure à celle des exemples 1 et 2 (368 g/h) la teneur en impuretés déterminée par spectrographie de masse était voisine de 50 ppm en poids dont:

| B | 0,05 | F | 0,04 | Na | 0,05 |
|----|---------|----|------|-----|---------|
| Mg | < 0,2 | Al | 2 | Si | ≦ 1 |
| P | 0,3 | S | 0,5 | Cl2 | 0,4 |
| K | 0,08 | Ca | 2 | V | 0,1 |
| Cr | 5 | Mn | 3 | Fe | 4 |
| Co | 0,1 | Ni | 0,6 | Cu | 1 |
| Zn | < 0,4 | As | 0,3 | Sn | 0,3 |
| Hf | 1 | Pb | 0,2 | Th | < 0,001 |
| U | < 0,002 | | | | |

Ces plats ont été utilisés, après découpage en pièces circulaires de diamètre 63,5 mm, à la fabrication de composants électroniques.

**Revendications**

1) Dispositif d'obtention de matériaux composés d'un substrat et d'un revêtement de titane purifié de forme plane dans lequel on met en oeuvre une cellule d'halogénation (5) de titane chauffée extérieurement par un bain (3) de sel fondu, garnie intérieurement près de la paroi d'un panier (6) délimité par deux grilles (15) et (16) qui contient l'éponge (7) de titane et vers le centre d'un substrat chauffé par effet Joule sur lequel l'halogénure formé se décompose pour donner ledit revêtement de titane purifié caractérisé en ce que le substrat est formé d'au moins une série de deux plats (13) reliés électriquement entre eux, qui s'allongent dans des plans sensiblement parallèles à la partie de la grille intérieure (15) du panier (6)la plus proche et sont équidistantes de ladite grille.

2) Dispositif selon la revendication 1 caractérisé en ce que la largeur d'un plat est comprise entre 0,5 et 2 fois la distance qui sépare le plat de la grille.

3) Dispositif selon la revendication 2 caractérisé en ce que la largeur d'un plat est comprise entre 0,75 et 1 fois la distance qui sépare le plat à la grille.

4) Dispositif selon la revendication 1 caractérisé en ce que la longueur occupée par les plats sur le périmètre que dessine leur largeur est inférieure ou égale à la longueur inoccupée.

5) Dispositif selon la revendication 4 caractérisé en ce que la largeur occupée par les plats est inférieure à la moitié de la longueur inoccupée.

6) Dispositif selon la revendication 1 caractérisé en ce que les plats sont en titane.

7) Dispositif selon la revendication 1 caractérisé en ce que les plats ont une épaisseur comprise entre 0,6 et 1 mm.

FIG.1

FIG.2

Office européen
des brevets

**RAPPORT DE RECHERCHE EUROPEENNE**

Numero de la demande

EP 90 42 0311

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | PATENT ABSTRACTS OF JAPAN, vol. 12, no. 191 (C-501)[3038], 3 juin 1988; & JP-A-62 294 175 (TOSHIBA CORP.) 21-12-1987 * En entier * --- | 1,6 | C 23 C 16/14 |
| X | PATENT ABSTRACTS OF JAPAN, vol. 12, no. 191 (C-501)[3038], 3 juin 1988; & JP-A-62 294 176 (TOSHIBA CORP.) 21-12-1987 * En entier * --- | 1,6 | |
| X | PATENT ABSTRACTS OF JAPAN, vol. 12, no. 191 (C-501)[3038], 3 juin 1988; & JP-A-62 294 177 (TOSHIBA CORP.) 21-12-1987 * En entier * --- | 1,6 | |
| X | PATENT ABSTRACTS OF JAPAN, vol. 12, no. 181 (C-501)[3038], 3 juin 1988; & JP-A-62 294 179 (TOSHIBA CORP.) 21-12-1987 * En entier * --- | 1,6 | **DOMAINES TECHNIQUES RECHERCHES (Int. Cl.5)** |
| A | FR-A-2 309 648 (ANVAR) ----- | | C 23 C |

Le présent rapport a été établi pour toutes les revendications

| Lieu de la recherche | Date d'achèvement de la recherche | Examinateur |
|---|---|---|
| LA HAYE | 12-09-1990 | JOFFREAU P.O. |